# EUROPEAN PATENT APPLICATION

(11) **EP 2 747 194 A1**
(43) Date of publication of application: **25.06.2014**
(21) Application number: 12306610.2
(22) Date of filing: 18.12.2012
(51) Int. Cl.: H01Q 1/12, H05K 7/14

(54) **Mounting apparatus for connecting a signal processing apparatus to a further signal processing apparatus, modular signal processing apparatus system and mounting method thereof**

(71) Applicant: Alcatel Lucent, 75007 Paris (FR)
(72) Inventor: Lange, Keld, 75443 Ötisheim (DE); Hochstaetter, Edgar, 71067 Sindelfingen (DE)
(74) Representative: Hofmann, Dirk

(57) **Abstract**

The embodiments of the invention relate to a mounting apparatus (MA) for connecting a signal processing apparatus (SPA1) to a further signal processing apparatus (SPA2). The mounting apparatus (MA) contains the further signal processing apparatus (SPA2), at least one first holding fixture (HF1) adapted to hold at least one first retaining means (RM1) of the signal processing apparatus (SPA1) and to guide the at least one first retaining means (RM1) from a first opened position to a first closed position, and at least one shifting means (SM) with a start position and an end position adapted to move the at least one first retaining means (RM1) from the first opened position to the first closed position and to set up at least one signal connection between the signal processing apparatus (SPA1) and the further signal processing apparatus (SPA2) by an adjustment of the at least one shifting means (SM) from the start position to the end position. The embodiments of the invention further relate to a modular signal processing apparatus system (MSPAS), which contains the mounting apparatus (MA) and the signal processing apparatus (SPA1) and to a mounting method for connecting the signal processing apparatus (SPA1) to the further signal processing apparatus (SPA2).

## Description

### FIELD OF THE INVENTION

Embodiments of the invention relate to mounting apparatuses and mounting methods and, more particularly but not exclusively, to a mounting apparatus and mounting method for a modular active antenna system.

### BACKGROUND

In mobile communication networks existing so far, an active antenna unit is installed as a single AA unit (AA = Active Antenna). A total weight of the single AA unit usually exceeds a so-called "one man lift" weight limit, which is usually in a range between 20 to 30 kg depending on a country or region. Therefore, two or more persons or even a crane are required to replace a defective AA unit or to upgrade the AA unit by a new AA unit with new technical features.

When a single device of the AA unit is defective or does not work anymore with a sufficient performance, a replacement of the whole AA unit is necessary, because interconnects within the AA unit have to be broken and have to be remade, when a new device has to be installed. This should be preferably done in a repair center or service station because the renewal of the interconnects requires highly skilled installation teams and specific functional tests for a validation of the new interconnect such as PIM tests (PIM = Passive Inter Modulation) for detecting and eliminating passive inter-modulation products caused by a non-linearity of a device or element and which are detectable as interference signals. Furthermore, each replacement usually requires a calibration of an antenna pointing direction.

Instead of the AA unit an RRH unit (RRH = Remote Radio Head) with a connected antenna may be used to provide wireless coverage in a mobile communication network. When an existing RRH unit needs to be replaced at an antenna mast by a new RRH unit, in first steps antennas and cable connections need to be disconnected from the existing RRH unit and screw couplings as part of a fixing device of the existing RRH unit need to be opened before the existing RRH unit is taken from a mounting suspension. In second steps, the new RRH unit is attached to the mounting suspension, further screw couplings as part of a fixing device of the new RRH unit need to be closed and the antennas and cable connections need to be reconnected to the new RRH unit. RF Coaxial Connectors (RF = Radio Frequency) such as 7/16 DIN connectors for RF cables between the RRH unit and the antennas usually require a torque controlled mount. Even if the 7/16 connector fulfils the IP68 specification with a solid particle protection, that provides no ingress of dust and a complete protection against contact and with a liquid ingress protection, that provides protection for an immersion into water beyond a depth of 1 m by a hermetical sealing, water may enter a feeder cable, if the new connection is not assembled by a highly skilled person.

### SUMMARY

A replacement of current AA units or RRH units requires highly skilled service technicians and/or a considerable amount of work and/or lifting equipment and therefore produces large replacement costs. Thus, it is an object of the invention to facilitate the replacement, to reduce an error rate of the replacement process and to reduce replacement costs in a radio communication network.

The object is achieved by a mounting apparatus for connecting a signal processing apparatus to a further signal processing apparatus. The mounting apparatus contains the further signal processing apparatus and at least one first holding fixture adapted to hold at least one first retaining means of the signal processing apparatus and to guide the at least one first retaining means from a first opened position to a first closed position. The mounting apparatus further contains at least one shifting means with a start position and an end position adapted to move the at least one first retaining means from the first opened position to the first closed position and to set up at least one signal connection between the signal processing apparatus and the further signal processing apparatus by an adjustment of the at least one shifting means from the start position to the end position.

The object is further achieved by a modular signal processing apparatus system, which contains the mounting apparatus and the signal processing apparatus. The modular signal processing apparatus may be for example a modular active antenna system for processing at least one of transmission radio frequency signals and received radio frequency signals. In further embodiments, the modular signal processing apparatus may be a radio base station or a server, which consists of two or more plug-in units. Thereby, the signal processing apparatus and the further signal processing apparatus may be two of the plug-in units.

The object is even further achieved by a mounting method for connecting the signal processing apparatus to the further signal processing apparatus. The mounting method contains the step of inserting at least one first retaining means of the signal processing apparatus into at least one first holding fixture of the mounting apparatus, which contains the further signal processing apparatus. The mounting method further contains the steps of adjusting at least one shifting means of the mounting apparatus from a start position to an end position, whereby the at least one first retaining means is guided within the at least first holding fixture from a first opened position to a first closed position and whereby at least one signal connection is set up between the signal processing apparatus and the further signal processing apparatus.

The mounting apparatus may be for example a supporting frame with two ledges, which contain each contain one first holding fixture. The at least one first holding fixture may be for example a first elongated opening with a first opening at an edge or a flange of one of the ledges for inserting for example a first guiding pin of the at least one first retaining means. The first opened position may be for example a position of the at least one first retaining means with respect to the at least one first holding fixture, when the at least one first retaining means is inserted into the at least one first holding fixture and is supported by the at least one first holding fixture by its own weight and when the at least one shifting means is in the start position. The first closed position may be for example a further position of the at least one first retaining means with respect to the at least one first holding fixture, when the signal processing apparatus is connected to the further signal processing apparatus and when the at least one shifting means is in the end position.

The signal processing apparatus may be for example a so-called active part of a modular active antenna system, which processes transmit radio frequency signals with processing steps such as receiving optical digital transmission signals via an optical input fiber, conversion of the optical digital transmission signals into electrical digital transmission signals, conversion of the electrical digital transmission signals into analogue transmission signals, mixing up the analogue transmission signals from a low frequency to a high frequency in a range of for example MHz or GHz, power amplification of the high frequency transmission radio frequency signals, and/or which processes received radio frequency signals with processing steps such as power conditioning of amplified analogue received signals, performing a down mixing from a high frequency in the range of for example 700 MHz, 850 MHz, 900 MHz, 1.8 GHz, 2.1 GHz or 2.6 GHz to a low frequency in a range of up to 500 MHz or directly to a complex baseband signal at 0 Hz, converting the low frequency analogue received signals into digital received signals, converting the digital received signals into optical received signals, and providing the optical received signals to an optical output fiber.

In a further alternative, the signal processing apparatus may be a server such as a fax server, a print server, a name server etc. with processing steps such as receiving client requests, processing the client requests by a CPU (CPU = Central Processing Unit), storing information in a database on a hard disk and transmitting answers to the client requests. In an even further alternative, the signal processing apparatus may be an optical network node such as a router with processing steps such as receiving input optical signals by an optical input fiber, splitting the input optical signals for example by an AWG (AWG = Arrayed Waveguide Grating), converting the splitted optical signals into electrical signals, determining a receiver address of the electrical signals, converting the electrical signals into output optical signals, combining the output optical signals by a further AWG, and transmitting the output optical signals via an optical output fiber.

The further signal processing apparatus may be for example a so-called passive part of the modular active antenna system, which processes the transmission radio frequency signals with processing steps such as filtering the amplified high frequency transmission radio frequency signals for example by a bandpass filter and providing the filtered amplified high frequency transmission radio frequency signals to an antenna port, and/or which processes the receive transmission radio frequency signals with processing steps such as providing analogue receives signals from the antenna port or a further antenna port to a filter such as a duplex filter, filtering the analogue receives signals, and amplification of the filtered analogue receives signals by a low noise amplifier for obtaining the amplified analogue receives signals.

According to the further alternative with the signal processing apparatus being a server, the further signal processing apparatus may be for example a so-called KVM switch (KVM = keyboard, video and mouse) to which the server will be connected. The KVM switch allows a user to control multiple computers or servers from at least one keyboard, video monitor and/or mouse. Regarding the even further alternative with the signal processing apparatus being an optical network node, the further signal processing apparatus may be a further optical network node such as a further router or an optical power amplifier system for amplifying the output optical signals of the router.

Alternatively, the signal processing apparatus and the further signal processing apparatus may be plug-in units of a base station such as a transceiver, a power amplifier, a combiner for combining feeds from several transceivers so that transmit radio frequency signals from the various transceivers could be sent out through a single antenna, a duplexer for separating sending and receiving signals to/from the antennas, an alarm extension system, which collects working status alarms of the various units in the base station and extends the status alarms to operations and maintenance monitoring stations, and a baseband unit for signal modulation, encoding, radio frequency shifting etc.

The embodiments of the invention provide a first benefit of facilitating a fixation of the signal processing apparatus to the mounting apparatus and facilitating the at least one signal connection between the signal processing apparatus and the further signal processing apparatus. No tools such as wrenches are required for mounting the signal processing apparatus and for connecting the signal processing apparatus to the further signal processing apparatus. Furthermore, a connector of the signal processing apparatus does not need to be adjusted with respect to a further connector of the further signal processing apparatus by a technician, who mounts the signal processing apparatus to the mounting apparatus and connects the signal processing apparatus to the further signal processing apparatus. The adjustment is automatically achieved, when the at least one first retaining means of the signal processing apparatus is inserted into the at least one first holding fixture. Thereby, no highly skilled technicians are required for connecting the signal processing apparatus to the further signal processing apparatus.

The embodiments of the invention provide a second benefit of facilitating also a disassembly of the signal processing apparatus and the further signal processing apparatus by not requiring any tools or highly skilled technicians.

Based on the first benefit and the second benefit, the embodiments of the invention provide a third benefit of reducing installation costs or replacement costs.

Preferably, the first elongated opening contains first drop-out protection means. The first drop-out protection means may be for example a recess with a diameter adapted to an outer diameter of the first guiding pin. This feature of the invention provides the advantage of preventing a fall out of the first guiding pin from the first elongated opening, when the at least one shifting means is in the start position.

According to a preferred embodiment, the mounting apparatus may further contain at least one second holding fixture adapted to hold at least one second retaining means of the signal processing apparatus and to guide the at least one second retaining means from a second opened position to a second closed position, when the at least one shifting means is moved from the start position to the end position.

The at least one second holding fixture may be for example a second elongated opening with a second opening at the edge or the flange of the one of the ledges of the supporting frame for inserting for example a second guiding pin of the at least one second retaining means. The second opened position may be for example a position of the at least one second retaining means with respect to the at least one second holding fixture, when the at least one second retaining means is inserted into the at least one second holding fixture and is supported for example by an inner edge of the second elongated opening and when the at least one shifting means is in the start position. The second closed position may be for example a further position of the at least one second retaining means with respect to the at least one second holding fixture, when the signal processing apparatus is connected to the further signal processing apparatus and when the at least one shifting means is in the end position.

The preferred embodiment provides a first advantage of further improving a drop-out prevention of the signal processing apparatus, when the at least one shifting means is moved from the start position to the end position and during an operation time of the signal processing apparatus, when the signal processing apparatus is connected to the further signal processing apparatus. It provides a second advantage of eliminating or reducing vibrations impacting on the signal processing apparatus. Such vibrations may be generated for example by environmental conditions such as strong wind.

In a further preferred embodiment, the at least one shifting means may be located at the at least one first holding fixture and the at least one first holding fixture may be located below the at least one second holding fixture, when the signal processing apparatus and the further signal processing apparatus are connected and are in operation. The further preferred embodiment provides the benefit, that the technician, who installs or uninstalls the signal processing apparatus must only be able to catch the at least one first holding fixture and the at least one shifting means by his or her hands and it is not required, that the technician is able to catch the at least one second holding fixture by his or her hands. This is important in particular, when the signal processing apparatus needs to be installed in large heights such as an active part of an antenna system, which needs to be installed or uninstalled to a passive part of the antenna system at an antenna mast.

Preferably, the at least one second holding fixture is located within a range of 1 cm to 5 cm to a plane, which is spanned by an end face of an interface of the further signal processing apparatus for the at least one signal connection between the signal processing apparatus and the further signal processing apparatus. When the mounting apparatus contains for example the two ledges of the supporting frame, two second holding fixtures may be located at the two ledges within the distance of 5 cm to the plane spanned by the interface of the further signal processing apparatus. In such a case, the at least one second retaining means is preferably located at an end face of the signal processing apparatus, which contains an interface for the at least one signal connection between the signal processing apparatus and the further signal processing apparatus. Such a positioning of the at least one second holding fixture provides the benefit of eliminating or reducing vibrations nearby the at least one signal connection.

The at least one first holding fixture and preferably the at least one second holding fixture may be preferably adapted to provide a length of a travel distance, which is defined by an overlap length of connectors of the signal processing apparatus and the further signal processing apparatus and by a predefined safety distance. The overlap length is for example an immersion depth of a connector of the signal processing apparatus into a connector of the further signal processing apparatus for closing the at least one signal connection between the signal processing apparatus and the further signal processing apparatus. The immersion depth is for example in a range of 5 mm to 3 cm.

The predefined safety distance is a distance, which prevents a bumping of the connector of the signal processing apparatus into the connector of the further signal processing apparatus when the at least one second retaining means is inserted into the at least one second holding fixture. The predefined safety distance is for example in a range of 5 mm to 3 cm.

The at least one second elongated opening preferably contains a first guide rail for inserting the second guiding pin and a second guide rail with a direction perpendicular to a direction of the first guide rail for moving the second guiding pin, when the at least one shifting means is moved from the start position to the end position. Preferably, the first guide rail has a direction, which is perpendicular to a direction of the gravitational force, when the mounting apparatus is installed. A length of the second guide rail is preferably equal to or larger than the length of the travel distance.

Such an arrangement allows, that the first guide rail is able to bear a part of a total weight of the signal processing apparatus, when the second guiding pin is inserted into the first guide rail. Furthermore, the guiding of the second guiding pin within the second guide rail facilitates an insertion of the connector interface of the signal processing apparatus into the counterpart connector interface of the further signal processing apparatus.

In a further preferred embodiment, a shortest distance between an opening of the first elongated opening and an opening of the second elongated opening is smaller than a shortest distance between the first guiding pin and the second guiding pin. The further preferred embodiment provides the advantage of further improving a fall-out prevention of the signal processing apparatus during the installation or the uninstall process of the signal processing apparatus.

In an even further preferred embodiment, the at least one shifting means may be for example a closing device and the closing device is adapted to fix the signal processing apparatus to the mounting apparatus. The closing device may be for example a draw latch with a clamp and a latch arm. The clamp can be inserted into a deepening or a groove of the at least one first retaining means such as a part of a guiding pin, with an outer diameter that is smaller than a further outer diameter of an end piece of the guiding pin. The latch arm is movable from the start position to the end position and thereby moves the clamp and presses the clamp against the deepening or the groove of the at least one first retaining means and further moves the signal processing apparatus together with the at least first retaining means until the at least one signal connection between the signal processing apparatus and the further signal processing apparatus is established and closed, which means that signals such as optical or electrical signals can be transferred or transmitted from the signal processing apparatus to the further processing apparatus or backwards from the further signal processing apparatus to the signal processing apparatus. The even further preferred embodiment provides the benefit, that the at least one shifting means are not only applied for facilitating the at least one signal connection between the signal processing apparatus and the further signal processing apparatus but also fastening the signal processing apparatus at the mounting apparatus during the operation of the signal processing apparatus and the further signal processing apparatus.

Preferably, the mounting apparatus further contains at least one opening adapted to insert a third guiding pin of the signal processing apparatus. In such a case, a perpendicular of the at least one opening may be perpendicular to a perpendicular of the first elongated opening. The at least one opening may contain a first part with a first inner diameter and a second part with a second inner diameter smaller than the first inner diameter and equal to an outer diameter of the third guiding pin. A location of the first part may be adapted to the start position of the at least one shifting means and a location of the second part may be adapted to the end position of the at least one shifting means. This preferred embodiment provides the advantage of providing a further fixation of the signal processing apparatus for avoiding a movement of the signal processing apparatus in a direction parallel to the longitudinal axis of the first guiding pin.

Further advantageous features of the embodiments of the invention are defined and are described in the following detailed description.

### BRIEF DESCRIPTION OF THE FIGURES

The embodiments of the invention will become apparent in the following detailed description and will be illustrated by accompanying figures given by way of non-limiting illustrations.

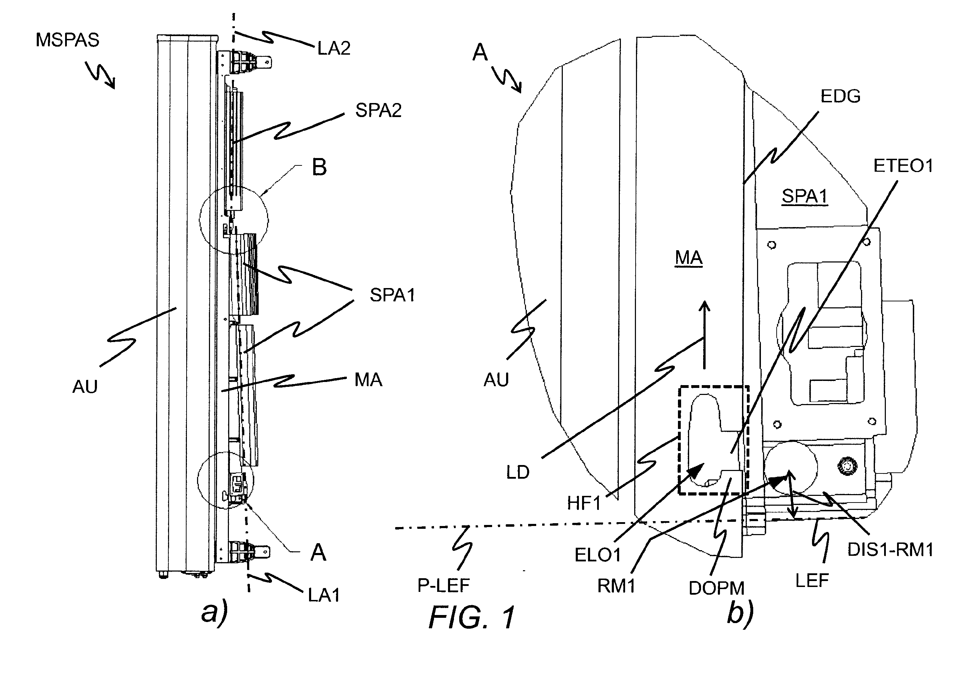

Figure 1 shows a side view of a modular signal processing apparatus system and an enlarged extract of the side view of the modular signal processing apparatus system with a first holding fixture and a first retaining means in a state after a first mounting step according to an embodiment of the invention.

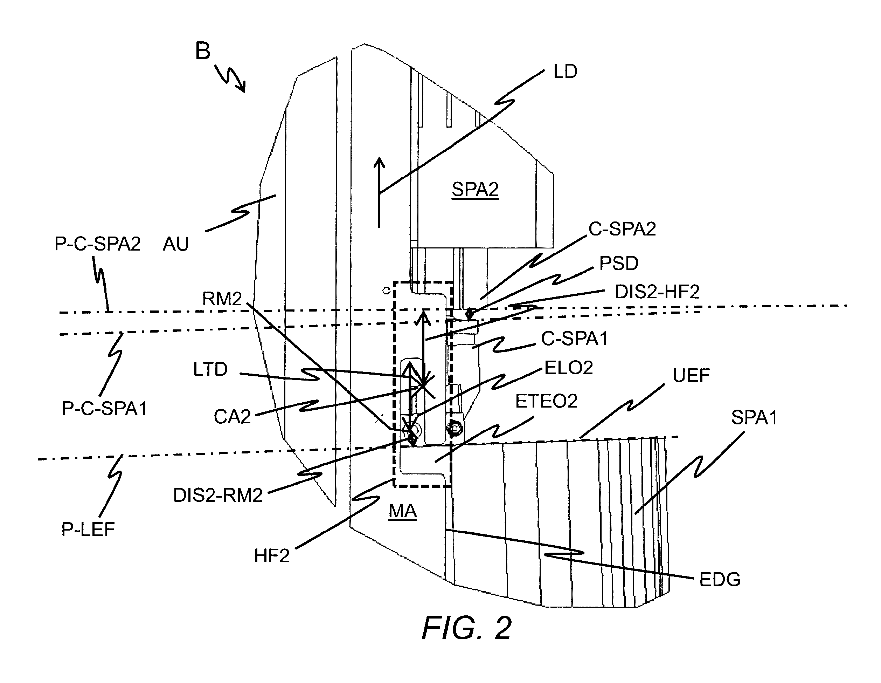

Figure 2 shows a further enlarged extract of the side view of the modular signal processing apparatus system with a second holding fixture and a second retaining means in the state after the first mounting step according to the embodiment of the invention.

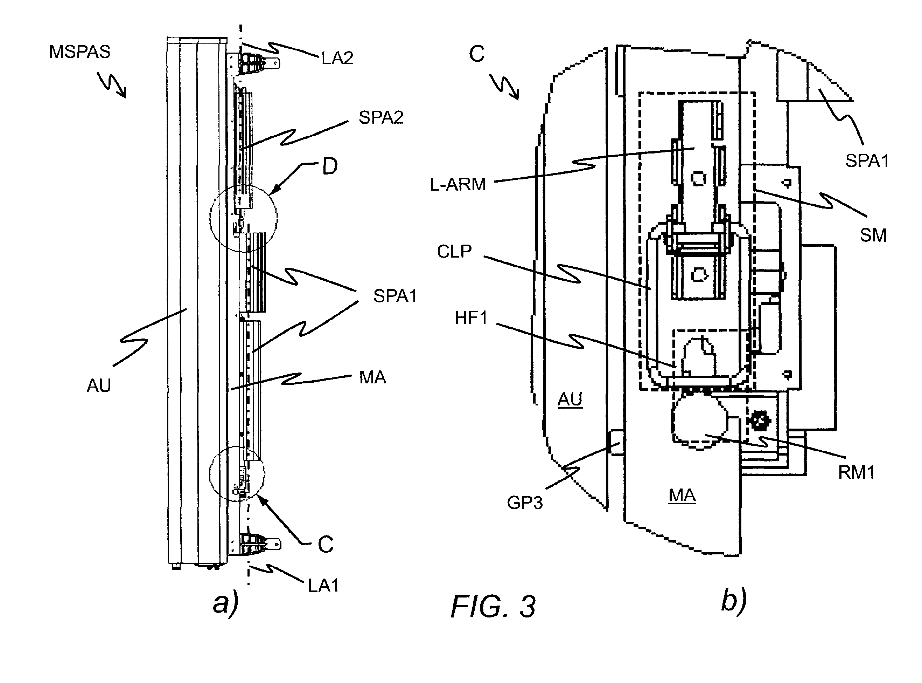

Figure 3 shows the side view of the modular signal processing apparatus system and an enlarged extract of the side view of the modular signal processing apparatus system with the first holding fixture, shifting means and the first retaining means in a state after a second mounting step according to the embodiment of the invention.

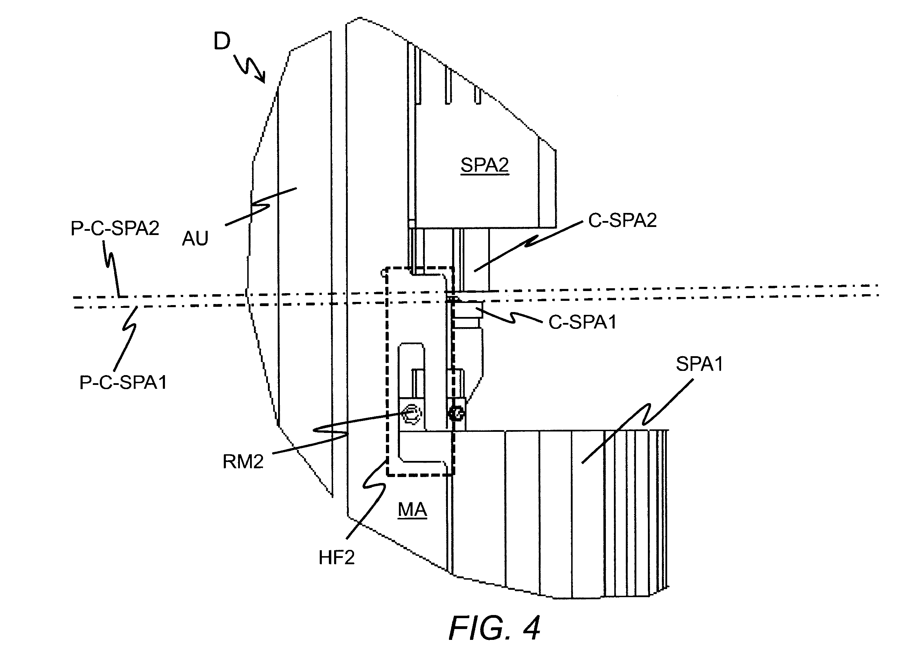

Figure 4 shows a further enlarged extract of the side view of the modular signal processing apparatus system with the second holding fixture and the second retaining means in the state after the second mounting step according to the embodiment of the invention.

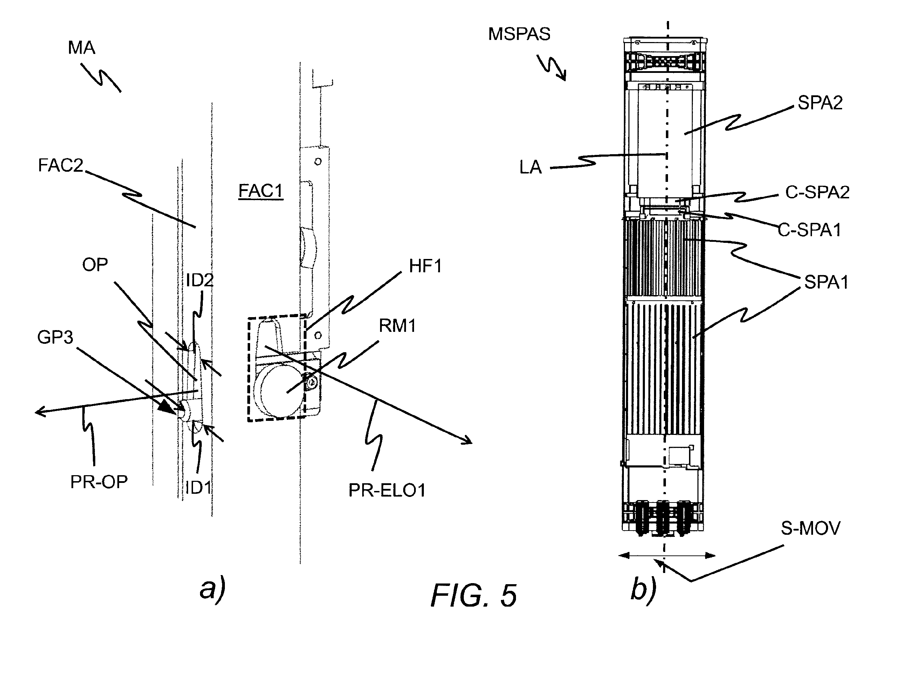

Figure 5 shows an enlarged extract of a mounting apparatus of the modular signal processing apparatus system with the first holding fixture and an opening of the mounting apparatus and two guiding pins of a signal processing apparatus in the state after the second mounting step according to a preferred embodiment of the invention and shows a further side view of the modular signal processing apparatus system indicating a movement direction to be prevented by the opening and one of the two guiding pins.

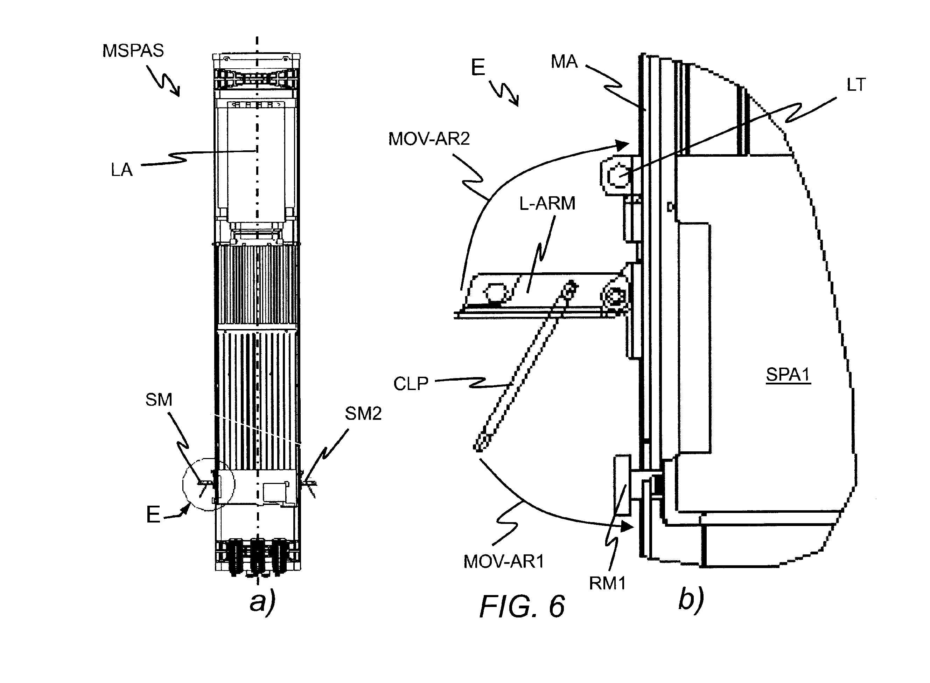

Figure 6 shows the further side view of the modular signal processing apparatus system and an enlarged extract of the further side view of the modular signal processing apparatus system with the shifting means, the mounting apparatus, the signal processing apparatus and the first retaining means in a state of a third mounting step according to the embodiment of the invention.

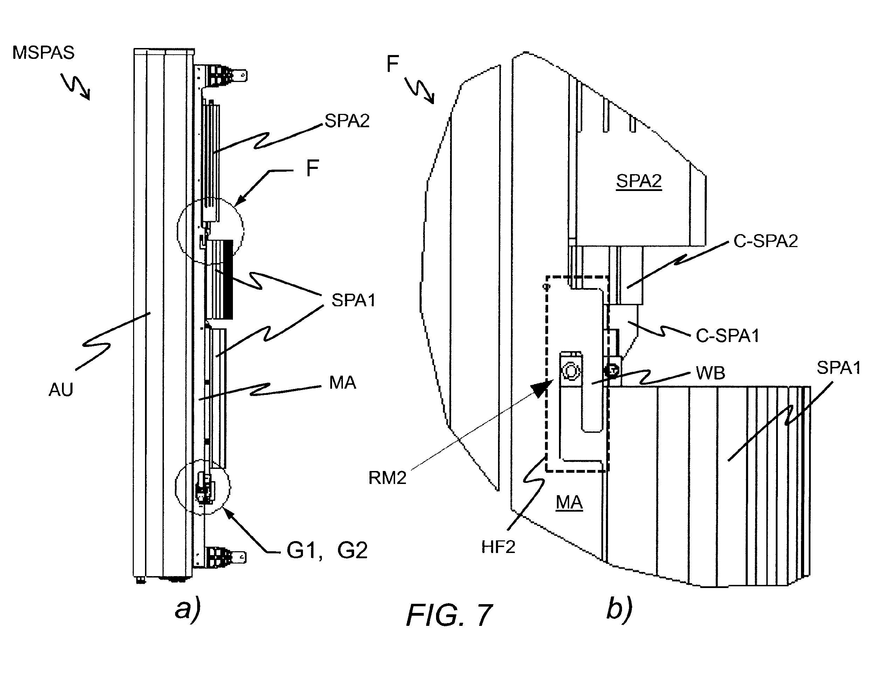

Figure 7 shows the side view of the modular signal processing apparatus system and an enlarged extract of the side view of the modular signal processing apparatus system with the second holding fixture and the second retaining means in a state after a fourth mounting step according to the embodiment of the invention.

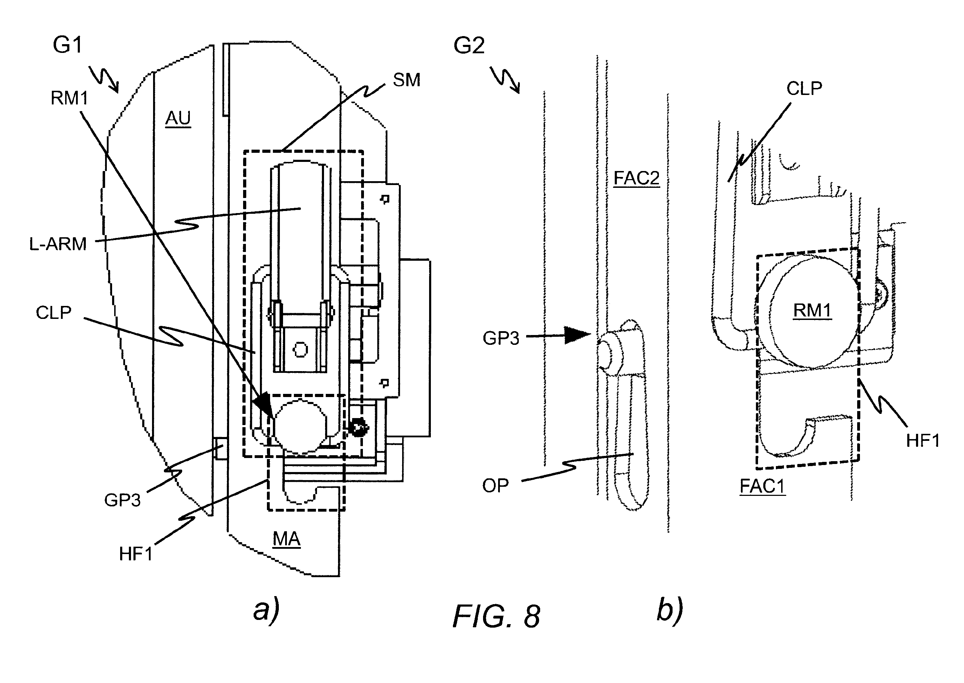

Figure 8 shows an enlarged extract of the side view of the modular signal processing apparatus system with the shifting means, the first holding fixture and the first retaining means and a further enlarged extract of the mounting apparatus of the modular signal processing apparatus system with the shifting means, the first holding fixture, the opening and the two guiding pins of the signal processing apparatus in the state after the fourth mounting step according to the embodiment of the invention.

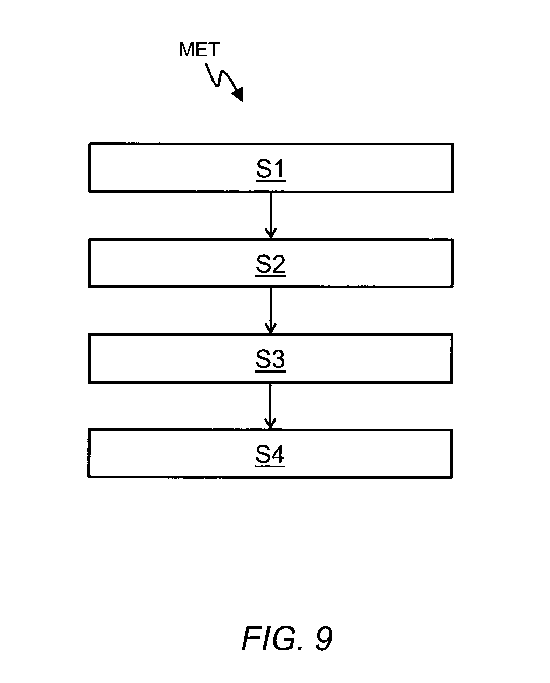

Figure 9 shows a block diagram of a mounting method according to the embodiment of the invention.

### DESCRIPTION OF THE EMBODIMENTS

Various example embodiments will now be described more fully with reference to the accompanying drawing in which an example embodiment is illustrated. In the figure, the thicknesses of lines, layers and/or regions may be exaggerated for clarity.

Accordingly, while example embodiments are capable of various modifications and alternative forms, embodiments thereof are shown by way of example in the figure and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figure.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

Figure 1 a) shows schematically in a side view a modular active antenna system MSPAS in a state after a first mounting step S1 (see Figure 9) as an example embodiment of a modular signal processing apparatus system. The state after the first mounting step S1 is characterized by the facts, that a second retaining means RM2 is preferably inserted into a second holding fixture HF2 (see Figure 2) and that a first retaining means RM1 is not yet inserted into a first holding fixture HF1 (see Figure 1 b). This means that a longitudinal axis LA1 of an easily attachable and detachable signal processing apparatus SPA1 may be not yet parallel to a longitudinal axis LA2 of a further signal processing apparatus SPA2 of the modular active antenna system MSPAS (see Figure 1 a).

The modular active antenna system MSPAS contains a mounting apparatus MA, an antenna unit AU with one, two or more than two antenna elements, the signal processing apparatus SPA1 and the further signal processing apparatus SPA2. The signal processing apparatus SPA1 may be for example a so-called active part of the modular active antenna system MSPAS, which processes transmit radio frequency signals with signal processing steps such as receiving optical digital transmission signals via an optical input fiber, conversion of the optical digital transmission signals into electrical digital transmission signals, conversion of the electrical digital transmission signals into analogue transmission signals, mixing up the analogue transmission signals from a low frequency to a high frequency in a range of for example MHz or GHz, power amplification of the high frequency transmission radio frequency signals, and/or which processes received radio frequency signals with further signal processing steps such as power conditioning of amplified analogue received signals, performing a down mixing from a high frequency in the range of for example 700 MHz, 850 MHz, 900 MHz, 1.8 GHz, 2.1 GHz or 2.6 GHz to a low frequency in a range of up to 500 MHz or directly to a complex baseband signal at 0 Hz, converting the low frequency analogue received signals into digital received signals, converting the digital received signals into optical received signals, and providing the optical received signals to an optical output fiber.

The mounting apparatus MA may be for example a supporting frame based on one, two or more than two elements. The one, two or more elements may be for example ledges based on metal. If two or more metal ledges are applied, the metal ledges may be interconnected by cross-ties. Figure 1 a) shows one of two ledges, which are applied with respect to the exemplarily described embodiment.

The antenna unit AU is mounted to a first side of the mounting apparatus MA, which may be a front side of the mounting apparatus MA. The further signal processing apparatus SPA2 is mounted to an upper part of a second side of the mounting apparatus MA, which may be a backward side of the mounting apparatus MA. The signal processing apparatus SPA1 is easily attachable to and detachable from the second side of the mounting apparatus MA and from the further signal processing apparatus SPA2 as will be described and explained in the following paragraphs and by further Figures 1 b) and Figure 2 to Figure 9. The attaching and detaching of the signal processing apparatus SPA1 is facilitated mainly by two first holding fixtures and by two shifting means of the mounting apparatus MA, which positions are indicated in Figure 1 a) by a section A of the modular active antenna system MSPAS, which is shown in Figure 1 b) as an enlarged extract of the side view of the modular active antenna system MSPAS. In further embodiments only one holding fixture and only one shifting means or more than two holding fixtures and more than two shifting means may be applied depending on a size and/or a weight of the signal processing apparatus SPA1 ..

In further alternatives the modular signal processing apparatus system may be a radio base station, an optical network node or a server, which all consist of two or more than two plug-in units. Thereby, the signal processing apparatus and the further signal processing apparatus may be two of the plug-in units.

The server such as a fax server, a print server, a name server etc. performs signal processing steps such as receiving client requests, processing the client requests by a CPU (CPU = Central Processing Unit) and a computer program product of a so-called motherboard, storing information in a database on a hard disk and transmitting answers to the client requests. The signal processing apparatus may be for example the hard disk and the further signal processing apparatus may be for example the motherboard.

The optical network node such as a router performs signal performs processing steps such as receiving input optical signals by an optical input fiber, splitting the input optical signals for example by an AWG (AWG = Arrayed Waveguide Grating), converting the splitted optical signals into electrical signals, determining a receiver address of the electrical signals by a CPU and computer program product, converting the electrical signals into output optical signals, combining the output optical signals by a further AWG, and transmitting the output optical signals via an optical output fiber. The signal processing apparatus may be for example the AWG and the further signal processing apparatus may be for example the further AWG.

The base station such as a so-called NodeB or enhanced NodeB contains plug-in units such as a transceiver, a power amplifier system, a combiner for combining feeds from several transceivers so that transmit radio frequency signals from the various transceivers could be sent out through a single antenna, a duplexer for separating sending and receiving signals to/from the antennas, an alarm extension system, which collects working status alarms of the various units in the base station and extends the status alarms to operations and maintenance monitoring stations, and a so-called baseband unit for signal modulation, encoding, radio frequency shifting etc. The signal processing apparatus may be for example the power amplifier system and the further signal processing unit may be for example the baseband unit.

Figure 1 b) shows schematically the section A of the modular active antenna system MSPAS in the state of the first mounting step S1 (see Figure 9). The ledge of the mounting apparatus MA contains the first holding fixture HF1 (indicated by a dashed line in Figure 1 b). The first holding fixture HF1 is a first elongated opening ELO1 in a longitudinal direction LD of the ledge with a first end-to-end opening ETEO1 from the first elongated opening ELO1 to an edge EDG of the ledge. In an alternative embodiment, the first holding fixture HF1 may be for example a snap fit or a spring lock as part of a metal rope, which is movable by the shifting means.

Figure 1 b) further shows the first retaining means RM1 of the signal processing apparatus SPA1. The first retaining means RM1 are preferably located at a lateral face of the signal processing apparatus SPA1 near a lower end face LEF of the signal processing apparatus SPA1 with a distance DIS1-RM1 between a central point of the the first retaining means RM1 and a plane P-LEF spanned by the lower end face LEF in a preferred predefined range between 5 mm to 5 cm. The first retaining means RM1 is preferably a guiding pin, which contains a longitudinal part with a first diameter, which is smaller than a diameter of the first end-to-end opening ETEO1 and a diameter of the first elongated opening ELO1. The guiding pin further contains an end piece with a second diameter, which is larger than the first diameter and which is preferably larger than the diameter of the end-to-end opening ETEO and the diameter of the first elongated opening ELO1. In an alternative embodiment, the first retaining means RM1 may be for example a metal protruding edge of the first signal processing apparatus SPA1 in which a spike of the shifting means hooks into.

The first holding fixture HF1 is adapted to insert the first retaining means RM1 of the signal processing apparatus and to guide the first retaining means RM1 from a first opened position as shown in Figure 3 b) to a first closed position as shown in Figure 8 a). For simplification, the shifting means are not shown in Figure 1 b) but will be discussed with respect to Figure 3b).

The first elongated opening ELO1 preferably contains drop-out protection means DOPM for the first retaining means RM1 at an upper end on which the gravitational force of the signal processing apparatus SPA1 acts on, when the first retaining means RM1 are inserted into the first holding fixture HF1. The drop-out protection means DOPM may be preferable a recess with a diameter, which is adapted to the first diameter of the first guiding pin (see Figure 1 b). In an alternative, the drop-out protection means DOPM may be for example an interlocking device such as a latch with a movable bar for narrowing or closing the first end-to-end opening ETEO1.

Preferably, a further ledge at an opposite lateral face of the mounting apparatus MA contains a further first holding fixture (see for example Figure 6 a) and an opposite lateral face of the signal processing apparatus SPA1 further contains a further first retaining means symmetrically arranged with respect to a longitudinal axis LA of the mounting apparatus MA (see Figure 6 a). In further embodiments, three or more than three first holding fixtures and first retaining means may be applied depending on a size and/or a weight of the signal processing apparatus SPA1.

Figure 2 shows a further enlarged extract of the side view of the modular active antenna system MSPAS with the second holding fixture HF2 and the second retaining means RM2 in the state of the first mounting step S1. The second holding fixture HF2 and the second retaining means RM2 may be applied in addition for facilitating the attachment and detachment of the signal processing apparatus SPA1 but the main principle of the invention is also applicable without the second holding fixture HF2 and the second retaining means RM2. The mounting apparatus MA may further contain two second holding fixtures HF2, which are adapted to insert each a second retaining means RM2 of the signal processing apparatus SPA1 and to guide the second retaining means RM2 from a second opened position as shown in Figure 2 to a second closed position as shown in Figure 7 b), when the two shifting means SM are moved from a start position (one shifting means is shown in Figure 3b) to an end position (see Figure 8 a).

The second holding fixture HF2 is a second elongated opening EL02 in the longitudinal direction LD of the ledge with a second end-to-end opening ETEO2 from the second elongated opening EL02 to the edge EDG of the ledge. The second end-to-end opening ETEO2 is a first guide rail for inserting the second retaining means RM2 and for providing a second opened position as an intermediate holding position of the signal processing apparatus SPA1, when the signal processing apparatus SPA1 is attached to or detached from the further signal processing apparatus SPA2 and the second elongated opening EL02 is a second guide rail perpendicular to the first guide rail for guiding the second retaining means RM2 from the second opened position to a second closed position being a position, when one signal connection or two or more than two signal connections of the signal processing apparatus SPA1 are connected by a connector C-SPA1 of the signal processing apparatus SPA1 to a corresponding signal connection or corresponding signal connections of the further signal processing apparatus SPA2 by a further connector C-SPA2 of the further signal processing apparatus SPA2 (see Figure 7 b). A central point CA2 of the second holding fixture HF2 may be preferably located by a shortest distance DIS2-HF2 in a range of 1 cm to 5 cm to a connector plane P-C-SPA2, which is spanned by an end face of the connector C-SPA2 of the further signal processing apparatus SPA2. After the first step S1 of the mounting method, the connector plane P-C-SPA2 and a further connector place P-C-SPA1, which is spanned by an end face of the connector C-SPA1 of the signal processing apparatus SPA1, may be not parallel to each other. In an alternative embodiment, the second holding fixture HF2 may be for example a further snap fit or a further spring lock as part of the metal rope.

The second holding fixture HF2 is preferably adapted to provide a length of a travel distance LTD, which is defined by an overlap length of connectors C-SPA1, CSPA2 of the signal processing apparatus SPA1 and the further signal processing apparatus SPA2 and by a predefined safety distance PSD. The overlap length is for example an immersion depth of a connector C-SPA1 of the signal processing apparatus SPA1 into a connector C-SPA2 of the further signal processing apparatus SPA2 for closing the at least one signal connection between the signal processing apparatus SPA1 and the further signal processing apparatus SPA2. The immersion depth is for example in a range of 5 mm to 3 cm.

The predefined safety distance PSD is a distance, which prevents a bumping of the connector C-SPA1 of the signal processing apparatus SPA1 into the connector C-SPA2 of the further signal processing apparatus SPA2 when the at least one second retaining means RM2 is inserted into the at least one second holding fixture HF2. The predefined safety distance PSD is for example in a range of 5 mm to 3 cm.

Figure 2 further shows the second retaining means RM2 as part of the signal processing apparatus SPA1. The second retaining means RM2 is preferably located at the lateral face of the signal processing apparatus SPA1 near an upper end face UEF of the signal processing apparatus SPA1 with a shortest distance DIS-RM2 in a predefined range between 5 mm to 3 cm between the second retaining means RM2 and a plane P-LEF spanned by the upper end face LEF.

The second retaining means RM2 is preferably a guiding pin, which contains a longitudinal part with a diameter, which is smaller than a diameter of the second end-to-end opening ETEO2 and a diameter of the second elongated opening ELO2. The second holding fixture HF2 is adapted to insert the second retaining means RM2 of the signal processing apparatus SPA1 and to guide the second retaining means RM2 from the second opened position as shown in Figure 4 to the second closed position as shown in Figure 7 b). In an alternative embodiment, the second retaining means RM2 may be for example a further metal protruding edge of the first signal processing apparatus SPA1 in which a spike as part of the metal rope hooks into.

Preferably, the further ledge at the opposite lateral face of the mounting apparatus MA contains a further second holding fixture and the opposite lateral face of the signal processing apparatus SPA1 further contains a further second retaining means symmetrically arranged with respect to the longitudinal axis LA of the mounting apparatus MA (see Figure 6 a). In further embodiments, three or more than three second holding fixtures and second retaining means may be applied depending on the size and/or the weight of the signal processing apparatus SPA1.

Figure 3a) shows the side view of the modular active antenna system MSPAS in a state after a second mounting step S2 (see Figure 9) according to the embodiment of the invention. The state after the second mounting step S2 is characterized by the facts, that both the second retaining means RM2 is inserted into the second holding fixture HF2 (see Figure 4) and that the first retaining means RM1 is inserted into the first holding fixture HF1 (see Figure 3b). This means that the longitudinal axis LA1 of the signal processing apparatus SPA1 may be parallel to the longitudinal axis LA2 of the further signal processing apparatus SPA2 (see Figure 3a).

Figure 3b) shows an enlarged extract C of the side view of the modular active antenna system MSPAS with the first holding fixture HF1, the shifting means SM and the first retaining means RM1. The first retaining means RM1 is inserted into the first holding fixture HF1. The shifting means SM have a start position (see Figure 3b) and an end position (see Figure 8 a) and are adapted to move the first retaining means RM1 from the first opened position to the first closed position and to set up one signal connection or more signal connections between the signal processing apparatus SPA1 and the further signal processing apparatus SPA2 by an adjustment of the shifting means SM from the start position to the end position. The start position is characterized by a position, when the first retaining means RM1 is inserted into the first holding fixture HF1 and when preferably the second retaining means RM2 is inserted into the second holding fixture HF2. The end position is characterized by a position, when the signal processing apparatus SPA1 is attached to the further signal processing apparatus SPA2 and one or more signal connections between the signal processing apparatus SPA1 and the further signal processing apparatus SPA2 are set up.

The shifting means SM may be preferably a closing device such as shown in Figure 3b), which is adapted to fix the signal processing apparatus SPA1 at or to the mounting apparatus MA. The shifting means SM may be for example a draw latch with a clamp CLP and a latch arm L-ARM, which is movable from the start position to the end position and thereby moves the clamp CLP and presses the clamp CLP against the deepening or the groove of the first retaining means RM1 and further moves the signal processing apparatus SPA1 together with the first retaining means RM1 until one signal connection or several signal connections between the signal processing apparatus SPA1 and the further signal processing apparatus SPA2 is/are established and closed, which means that signals such as optical or electrical signals can be transferred or transmitted from the signal processing apparatus SPA1 to the further processing apparatus SPA2 or backwards from the further signal processing apparatus SPA2 to the signal processing apparatus SPA1. The clamp CLP is inserted into and pressed against the deepening or the groove, which is defined by the longitudinal part of the first guiding pin with the first diameter, by the end piece of the first guiding pin with the second diameter and by the ledge of the mounting apparatus MA.

In an alternative embodiment, the shifting means SM may be for example an interlocking device such as a latch with a movable bar and a bolt, which may be placed into an opening of the latch to clamp the movable bar in the end position. Regarding the alternative embodiment using the metal rope, a clamping device of the shifting means SM may clamp the metal rope and an adjustment of the shifting means SM from the start position to the end position may provide a longitudinal shift of the metal rope.

Preferably, the further ledge at the opposite lateral face of the mounting apparatus MA contains further shifting means symmetrically arranged with respect to the longitudinal axis LA of the mounting apparatus MA (see Figure 6 a). In further embodiments, three or more than three shifting means may be applied depending on the size and/or the weight of the signal processing apparatus SPA1.

Figure 3b) further shows a third guiding pin GP3 as an example of third retaining means of the signal processing apparatus SPA1, which is described in more detail with respect to Figure 5 b) and Figure 8 b).

Figure 4 shows a further enlarged extract D of the side view of the modular active antenna system MSPAS with the second holding fixture HF2 and the second retaining means RM2 in the state after the second mounting step S2 according to the embodiment of the invention. After the second mounting step S2 of the mounting method, the connector plane P-C-SPA2 and a further connector place P-C-SPA1 may be preferably parallel to each other as shown in Figure 4.

Figure 5 a) shows an enlarged extract of the mounting apparatus MA of the modular active antenna system MSPAS at a location of the first holding fixture HF1 according to a further preferred embodiment. The shifting means SM are not shown in Figure 5 a) for simplification.

The mounting apparatus MA further contains an opening OP, which is adapted to insert the third guiding pin GP3 of the signal processing apparatus SPA1, which is not shown in Figure 5 a) for simplification. Preferably, the opening OP may be arranged at the mounting apparatus MA in such a way, that a perpendicular PR-OP of the opening OP is perpendicular to a perpendicular PR-ELO1 of the first elongated opening ELO1. This can be realized for example by an edge profile of the ledge as shown in Figure 5 a). A first face FAC1 of the edge profile contains the first elongated opening ELO1 and a second face FAC2 of the edge profile with a right angle to the first face FAC1 contains the opening OP. The first opening OP and the first holding fixture HF1 may be located at a same length portion of the edge profile as shown in Figure 5 a). According to an alternative embodiment, the first opening OP may be located centrally between the first holding fixture HF1 and the second holding fixture HF2.

The opening OP contains a first part with a first inner diameter ID1 and a second part with a second inner diameter ID2 smaller than the first inner diameter ID1 and preferably equal to an outer diameter of the third guiding pin GP3. A location of the first part is adapted to the start position of the shifting means SM (see Figure 3b) and a location of the second part is adapted to the end position of the at shifting means SM (see Figure 8 a). The opening OP and the third guiding pin GP3 provide the advantage of providing a further fixation of the signal processing apparatus SPA1 for avoiding a movement of the signal processing apparatus in a movement direction S-MOV, which is perpendicular to the longitudinal axis LA of the modular active antenna system MSPAS and which is parallel to the perpendicular PR-EOL1 of the first elongated opening ELO1 (see Figure 5 a) and Figure 5 b), which shows the modular active antenna system MSPAS by a further side view for which the modular active antenna system MSPAS has been rotated by 90 degree along the longitudinal axis LA.

Preferably, the further ledge at the opposite lateral face of the mounting apparatus MA contains a further opening symmetrically arranged with respect to the longitudinal axis LA of the mounting apparatus MA, which is adapted to insert a further third guiding pin of the signal processing apparatus SPA1. In further embodiments, three or more than three openings may be applied depending on the size and/or the weight of the signal processing apparatus SPA1.

Figure 6 a) shows the further side view of the modular active antenna system MSPAS in a state of a third mounting step S3 (see Figure 9), when the shifting means SM and a further shifting means SM2 are adjusted for attaching the signal processing apparatus SPA1 to the further signal processing apparatus SPA2. Figure 6 b) shows an enlarged extract E of the further side view of the modular active antenna system MSPAS with the shifting means SM, the mounting apparatus MA, the signal processing apparatus SPA1 and the first retaining means RM1.

During the mounting step S3, the clamp CLP of the draw latch as an example of the shifting means SM is moved by a first movement direction MOV-AR1 towards the first guiding pin as an example of the first retaining means RM1 and is inserted into the deepening or the groove provided by the first guiding pin and the ledge such as the edge profile shown in Figure 5 a) of the mounting apparatus MA. In a fourth mounting step S4 (see Figure 9), the latch arm L-ARM of the draw latch is moved in an opposite second movement direction MOV-AR2 towards the edge profile of the mounting apparatus MA until the latch arm L-ARM is clamped by a latch LT of the shifting means SM.

Figure 7 a) shows the side view of the modular active antenna system MSPAS in a state after the fourth mounting step S4 (see Figure 9) according to the embodiment of the invention. An enlarged extract F of the side view of the modular active antenna system MSPAS with the second holding fixture HF2, the second retaining means RM2, the mounting apparatus MA, the signal processing apparatus SPA1 and the further signal processing apparatus SPA2 is shown in Figure 7 b). The main difference with respect to the arrangement as shown in Figure 4 is the fact, that a gap between the connector C-SPA1 and the connector C-SPA2 is closed, because the connector C-SPA1 is inserted with the immersion depth into the connector C-SPA2 and connected to the connector C-SPA2. A drop-out of the signal processing apparatus SPA1 is prevented by a web WB as part of a border of the second elongated opening ELO2.

Figure 8 a) shows an enlarged extract G1 of the side view of the modular active antenna system MSPAS with the shifting means SM, the first holding fixture HF1 and the first retaining means RM1 in the state after the fourth mounting step S4. The latch arm L-ARM is in the end position and the clamp CLP and the first retaining means RM1 have been lifted. The clamp CLP clasps the first guiding pin of the first retaining means RM1 and thereby holds the signal processing apparatus SPA1 in a connected state with at least one signal connection between the signal processing apparatus SPA1 and the further signal processing apparatus SPA2 and also prevents a drop-out of the signal processing apparatus SPA1 from the mounting apparatus MA.

Figure 8 b) shown a further enlarged extract G2 of the side view of the modular active antenna system MSPAS with the shifting means SM and the first holding fixture HF1 of the mounting apparatus MA and the first retaining means RM1, the opening OP and the third guiding pin GP3 of the signal processing apparatus SPA1 in the state after the fourth mounting step S4. The third guiding pin GP3 is located at the second part of the opening OP with the second inner diameter ID2 preferably equal to the outer diameter of the third guiding pin GP3.

In a preferred embodiment as shown in Figure 8 a) and 8b), the shifting means SM are located at the first holding fixture HF1 and the first holding fixture HF1 is located at the mounting apparatus MA below the second holding fixture HF2 as shown in Figure 7 a), when the signal processing apparatus SPA1 and the further signal processing apparatus SPA2 are connected and are in operation.

In an even further preferred embodiment, a shortest distance between the first end-to-end opening ETEO1 of the first elongated opening ELO1 and the second end-to-end opening ETEO2 of the second elongated opening EL02 is smaller than a shortest distance between the first guiding pin of the first retaining means RM1 and the second guiding pin of the second retaining means RM2.

Referring to Figure 9, an exemplarily flow diagram of a method MET in accordance to a preferred embodiment of the invention is shown. The number of the steps for performing the method MET is not critical, and as can be understood by those skilled in the art, that the number of the steps may vary without departing from the scope of the embodiments of the invention as defined in the appended claims.

In the first optional but preferable step S1, the second retaining means RM2 of the signal processing apparatus SPA1 are inserted into the second holding fixture HF2 of the mounting apparatus MA (see Figure 2).

In the second step S2, the first retaining means RM1 of the signal processing apparatus SPA1 are inserted into the first holding fixture HF1 of the mounting apparatus MA (see Figure 3b) and Figure 5 a).

In the third step S3, the clamp CLP of the shifting means SM is moved by a first movement direction MOV-AR1 towards the first guiding pin of the first retaining means RM1 and is inserted into the deepening or the groove, which is provided by the first guiding pin and the edge profile of the mounting apparatus MA (see Figure 6 b).

In the fourth step S4, the latch arm L-ARM of the draw latch is moved towards the edge profile of the mounting apparatus MA until the latch arm L-ARM is clamped by the latch LT of the shifting means SM (see Figure 6 b).

The third step S3 and the fourth step S4 adjusting the shifting means SM of the mounting apparatus MA from the start position to the end position, whereby the first retaining means RM1 is guided by the first holding fixture HF1 from the first opened position to the first closed position and whereby one signal connection or several signal connections between the signal processing apparatus SPA1 and the further signal processing apparatus SPA2 is or are set up.

The third step S3 and the fourth step S4 may be replaced by corresponding steps such as moving the bar and inserting the bolt, when the draw latch is replaced by the latch with contains the movable bar and the bolt.

## Claims

1. A mounting apparatus (MA) for connecting a signal processing apparatus (SPA1) to a further signal processing apparatus (SPA2), said mounting apparatus (MA) comprising:
- said further signal processing apparatus (SPA2),
- at least one first holding fixture (HF1) adapted to hold at least one first retaining means (RM1) of said signal processing apparatus (SPA1) and to guide said at least one first retaining means (RM1) from a first opened position to a first closed position, and
- at least one shifting means (SM) with a start position and an end position adapted to move said at least one first retaining means (RM1) from said first opened position to said first closed position and to set up at least one signal connection between said signal processing apparatus (SPA1) and said further signal processing apparatus (SPA2) by an adjustment of said at least one shifting means (SM) from said start position to said end position.

2. Mounting apparatus (MA) according to claim 1, wherein said at least one first holding fixture (HF1) is a first elongated opening (ELO1) for a first guiding pin of said at least one first retaining means (RM1).

3. Mounting apparatus (MA) according to claim 2, wherein said first elongated opening (ELO1) comprises first drop-out protection means (DOPM) for said first guiding pin.

4. Mounting apparatus (MA) according to claim 3, wherein said first drop-out protection means (DOPM) is a recess with a diameter adapted to an outer diameter of said first guiding pin.

5. Mounting apparatus (MA) according to any of the preceding claims, wherein said mounting apparatus (MA) further comprises at least one second holding fixture (HF2) adapted to hold at least one second retaining means (RM2) of said signal processing apparatus (SPA1) and to guide said at least one second retaining means (RM2) from a second opened position to a second closed position, when said at least one shifting means (SM) is moved from said start position to said end position.

6. Mounting apparatus (MA) according to claim 5, wherein said at least one shifting means (SM) is located at said at least one first holding fixture (HF1) and wherein said at least one first holding fixture (HF1) is located at said mounting apparatus (MA) below said at least one second holding fixture (HF2), when said signal processing apparatus (SPA1) and said further signal processing apparatus (SPA2) are connected and are in operation.

7. Mounting apparatus (MA) according to claim 5 or claim 6, wherein said at least one second holding fixture (HF2) is located with a shortest distance (DIS2-HF2) in a range between 1 cm to 5 cm to a plane (P-C-SPA2) and wherein said plane (P-C-SPA2) is spanned by an end face of an interface (C-SPA2) of said further signal processing apparatus (SPA2) for said at least one signal connection.

8. Mounting apparatus (MA) according to any of the preceding claims 5 to 7, wherein said at least one second holding fixture (HF2) is a second elongated opening (EL02) for a second guiding pin of said at least one second retaining means (RM2), wherein said first elongated opening (EL02) comprises a first guide rail (ETE02) for inserting said second guiding pin and a second guide rail (EL02) with a direction perpendicular to a direction of said first guide rail (ETE02) for moving said second guiding pin, when said at least one shifting means (SM) is moved from said start position to said end position.

9. Mounting apparatus (MA) according claim 2 and claim 8, wherein a shortest distance between an opening (ETEO1) of said first elongated opening (ELO1) and an opening (ETE02) of said second elongated opening (EL02) is smaller than a shortest distance between said first guiding pin and said second guiding pin.

10. Mounting apparatus (MA) according to any of the preceding claims, wherein said at least one shifting means (SM) is a closing device and wherein said closing device is adapted to fix said signal processing apparatus (SPA1) to said mounting apparatus (MA).

11. Mounting apparatus (MA) according to claim 10, wherein said closing device is at least one draw latch.

12. Mounting apparatus (MA) according to claim 2, wherein said mounting apparatus (MA) further comprises at least one opening (OP) adapted to insert a third guiding pin (GP3) of said signal processing apparatus (SPA1), wherein a perpendicular (PR-OP) of said at least one opening (OP) is perpendicular to a perpendicular (PR-ELO1) of said first elongated opening (ELO1), wherein said at least one opening (OP) comprises a first part with a first inner diameter (ID1) and a second part with a second inner diameter (ID2) smaller than said first inner diameter (ID1) and equal to an outer diameter of said third guiding pin (GP3), wherein a location of said first part is adapted to said start position of said at least one shifting means (SM) and wherein a location of said second part is adapted to said end position of said at least one shifting means (SM).

13. A modular signal processing apparatus system (MSPAS) comprising a mounting apparatus (MA) according to any of the preceding claims and a signal processing apparatus (SPA1) comprising at least one first retaining means (RM1) adapted to be inserted into at least one first holding fixture (HF1) of said mounting apparatus (MA).

14. Modular signal processing apparatus system (MSPAS) according to claim 13, wherein said modular signal processing apparatus system (MSPAS) is a modular active antenna system.

15. A mounting method (MET) for connecting a signal processing apparatus (SPA1) to a further signal processing apparatus (SPA2), said mounting method (MET) comprising the steps of:
- inserting (S1) at least one first retaining means (RM1) of said signal processing apparatus (SPA1) into at least one first holding fixture (HF1) of a mounting apparatus (MA) comprising said further signal processing apparatus (SPA2), and
- adjusting (S3, S4) at least one shifting means (SM) of said mounting apparatus (MA) from a start position to an end position, whereby said at least one first retaining means (RM1) is guided by said at least first holding fixture (HF1) from a first opened position to a first closed position and whereby at least one signal connection between said signal processing apparatus (SPA1) and said further signal processing apparatus (SPA2) is set up.
